(19) Europäisches Patentamt
European Patent Office
Office européen des brevets

(11) Veröffentlichungsnummer: **0 000 342**
**B1**

(12) # EUROPÄISCHE PATENTSCHRIFT

(45) Veröffentlichungstag der Patentschrift: **25.11.81**

(51) Int. Cl.[3]: **C 09 D 11/10, C 08 F 2/50, C 09 D 7/12**

(21) Anmeldenummer: **78100236.5**

(22) Anmeldetag: **26.06.78**

(54) **Photopolymerisierbare Bindemittel.**

(30) Priorität: **08.07.77 DE 2730897**

(43) Veröffentlichungstag der Anmeldung:
**24.01.79 Patentblatt 79/2**

(45) Bekanntmachung des Hinweises auf die Patenterteilung:
**25.11.81 Patentblatt 81/47**

(84) Benannte Vertragsstaaten:
**CH DE FR GB SE**

(56) Entgegenhaltungen:
**GB - A - 1 486 911**
**US - A - 3 933 682**
**US - A - 3 966 573**

(73) Patentinhaber: **BASF Aktiengesellschaft**
**Carl-Bosch-Strasse 38**
**D-6700 Ludwigshafen (DE)**

(72) Erfinder: **Kuesters, Werner, Dr.**
**Osloer Weg 46**
**D-6700 Ludwigshafen (DE)**
Erfinder: **Heil, Guenter, Dr.**
**Londoner Ring 72**
**D-6700 Ludwigshafen (DE)**
Erfinder: **Fischer, Martin, Dr.**
**Elbinger Weg 1**
**D-6700 Ludwigshafen (DE)**
Erfinder: **Eisert, Manfred, Dr.**
**Berner Weg 26**
**D-6700 Ludwigshafen (DE)**
Erfinder: **Kast, Hellmut, Dr.**
**An der Tuchbleiche 4**
**D-6712 Bobenheim-Roxheim 2 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**EP 0 000 342 B1**

Photopolymerisierbare Bindemittel

Die Erfindung betrifft photopolymerisierbare Bindemittel für Druckfarben, Überzüge und Druckplatten auf der Basis mindestens einer photopolymerisierbaren olefinisch ungesättigten Verbindung sowie gegebenenfalls einer polymeren Bindemittelkomponente, die eine vorteilhafte Diaminobenzophenon-Verbindung als Photosensibilisator enthalten.

Aminogruppenhaltige Benzophenonderivate sind bekannt. Besonders vielfach ist 4,4'-Bis(N-dimethylamino)benzophenon (Michlers Keton) und seine Anwendung in Photoinitiator-Systemen oder als Photosensibilisator für photopolymerisierbare Systeme beschrieben (vgl. DT—OS 15 22 359). Es ist ein Nachteil von Michlers Keton, daß seine toxischen Eigenschaften für manche Anwendungszwecke nicht befriedigen, ferner seine begrenzte Löslichkeit in vielen organischen Lösungsmitteln und seine begrenzte Verträglichkeit mit manchen polaren photopolymerisierbaren Bindemitteln zu wünschen übrig läßt, wodurch bei Erfordernis höherer Konzentrationen an Photosensibilisatoren leicht Trübungen in den entsprechenden Gemischen auftreten, die eine Photopolymerisation störend beeinflussen.

Da es für die Verbesserung der Verträglichkeit von polaren organischen Verbindungen untereinander keine allgemeine Regel gibt, war es für den Fachmann nicht vorhersehbar, wie die Verträglichkeit von Michlers Keton, einer sehr polaren Substanz, mit polaren photopolymerisierbaren Verbindungen verbessert werden konnte. In den US-Patentschriften 3 933 682, 3 966 573 und 3 915 824 sind eine Vielzahl von aromatischen Carbonylverbindungen, auch Benzophenon-Derivaten, als Photoinitiatoren für Bindemittel enthaltende photopolymerisierbare Mischungen beschrieben. Aus diesen Durchschriften erhält man jedoch nur die Lehre, daß die Wirksamkeit der aromatischen Carbonylverbindungen als Photosensibilisatoren dadurch erhöht werden kann, daß man ihnen bestimmte andere Substanzen, insbesondere halogenierte Kohlenstoffe als Aktivatoren zusetzt. Ein Hinweis, wie die Verträglichkeit von Michlers Keton mit polaren Bindemitteln verbessert werden kann bzw. ob oder welche Substanzen aus der großen Anzahl der als Photoinitiatoren in Betracht kommenden Verbindungen diese Eigenschaften besitzen, ist in diesen Patentschriften nicht zu finden.

Der vorliegenden Erfindung lag die Aufgabe zugrunde, für photopolymerisierbare Bindemittel einen Ersatz für Michlers Keton zu finden, der verbesserte toxische Eigenschaften, eine verbesserte Verträglichkeit mit photopolymerisierbaren Gemischen aufweist und eine vielseitige Verwendung als Photosensibilisator bzw. Komponente in Photoinitiator-Systemen für photopolymerisierbare Massen gestattet.

Es wurde nun gefunden, daß photopolymerisierbare Bindemittel für Druckfarben, Überzüge und Druckplatten, im wesentlichen bestehend aus mindestens einer photopolymerisierbaren olefinisch ungesättigten VErbindung sowie gegebenenfalls einer polymeren Bindemittelkomponente, die eine Diaminobenzophenon-Verbindung als Photosensibilisator enthalten, die gewünschten verbesserten Eigenschaften zeigen, wenn sie eine Diaminobenzophenon-Verbindung der Formel (I)

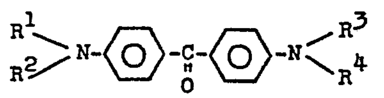

(I)

enthalten, worin $R^1$ und $R^3$ H—$(OR^5)_x$-Reste mit $R^5$=Alkylen mit 2 bis 3 C-Atomen, x=1, 2 oder 3, $R^2$ und $R^4$ Alkylreste mit 1 bis 4 C-Atomen oder Reste der für $R^1$ und $R^3$ genannten Art darstellen.

Beispiele solcher Verbindungen sind 4,4'-Bis (N-β-hydroxyäthyl-N-methylamino)benzophenon, 4,4'-Bis(N-β-hydroxyäthyl-N-äthyl-amino)-benzophenon, 4,4'-Bis(N-β-hydroxyäthyl-N-propyl-amino)-benzophenon, 4,4'-Bis(N-β-hydroxypropyl-N-methyl-amino)benzophenon, 4,4'-Bis-(N-hydroxypropyl-N-methyl-amino)benzophenon, 4,4'-Bis(N-hydroxyäthoxyäthyl-N-methyl-amino)benzophenon der Formel (II)

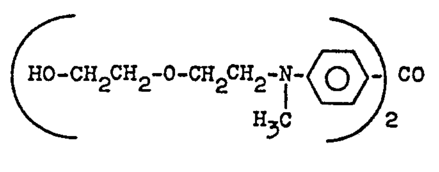

(II),

ferner 4,4'-Bis(N,N-dihydroxyalkyl-amino)-benzophenone wie 4,4'-Bis(N,N-di-β-hydroxyäthyl-amino)-benzophenon, 4,4'-Bis(N,N-di-β-hydroxypropyl-amino)benzophenon oder unsymmetrisch substituierte Benzophenone wie 4-(N,N-di-β-hydroxyäthylamino)-4'-(N,N-di-β-hydroxypropylamino)benzophenon der Formel (III)

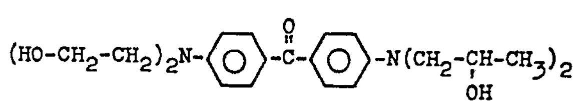

(III)

Sehr geeignet sind die 4,4'-Bis(N-hydroxyäthyl-N-$C_1$—$C_4$-alkyl-amino)benzophenone.

Einen technisch einfachen Weg zur Herstellung von N-Hydroxyalkylaminoderivate des Benzophenons stellt die folgende Umsetzung dar:

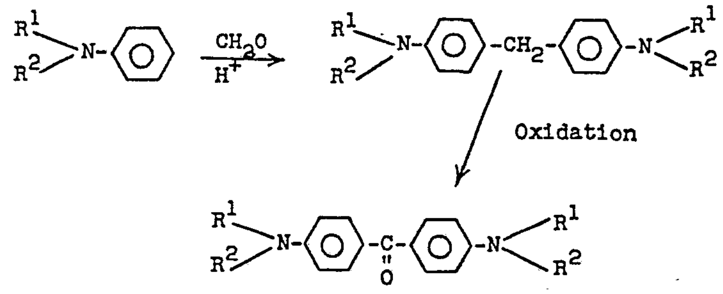


Durch Einsatz von Gemischen verschiedener N-Hydroxyalkyl-N-alkyl-aniline bzw. N,N-Dihydroxyalkylaniline, für die Umsetzung mit Formaldehyd bzw. Paraformaldehyd in Gegenwart von Säure lassen sich auch unsymmetrische Derivate des Diaminobenzophenons herstellen, wobei als Zwischenprodukte stets die entsprechend substituierten Diaminophenylmethane entstehen, die dann durch Oxidation mit Sauerstoff z.B. in Gegenwart von Chloranil und Eisenkomplexen des Dihydrodibenzotetraaza-annulens in die entsprechend substituierten Diaminobenzophenone umgewandelt werden können. Die erfindungsgemäß als Photosensibilisatoren verwendeten Verbindungen lassen sich dann leicht als meist nadelförmig kristalline feste Substanzen mit Schmelzpunkten über 100°C isolieren und reinigen.

Die erfindungsgemäß in photopolymerisierbaren Bindemitteln verwendeten Diaminobenzophenon-Verbindungen weisen bei mit Michlers Keton vergleichbarer Aktivität als Photosensibilisator die Vorteile auf, daß sie weniger toxisch als Michlers Keton sind, in vielen organischen Lösungsmitteln eine bessere Löslichkeit und mit vielen polaren photopolymerisierbaren Gemischen eine verbesserte Verträglichkeit aufweisen.

Von besonderem Vorteil ist es, im erfindungsgemäßen Bindemittel neben der Diaminobenzophenon-Verbindung einen weiteren bekannten Photoaktivator mitzuverwenden, wie Benzoin, Benzoinäther, Anthrachinon, Benzil, Benzilmonoalkylketale, Fluorenon, Fluoren, Diacetyl und insbesondere Benzophenon oder ein im Bereich von 300 bis 380 nm niedrig absorbierendes Benzophenonderivat, wie solchen mit einem Extinktionskoeffizienten $\varepsilon_{360\ nm} < 200$, wobei die für die Kombination mit Michlers Keton bekannten molaren Verhältnisse und Mengen angewandt werden können.

Als photopolymerisierbare olefinisch ungesättigten Verbindungen kommen die bekannten niedrigmolekularen Monomeren und Oligomeren (insbesondere mit einem Molekulargewicht unter 2 000) in Frage, die für photopolymerisierbare Bindemittel für Druckfarben, Überzugsmittel und für Druckplatten an sich bekannt sind, wobei sich natürlich die Art der Monomeren nach dem Anwendungszweck richtet und nach dem gegebenenfalls mitverwendeten polymeren Bindemittel, mit dem sie verträglich sein sollen. Bevorzugt sind Monomere mit zwei- oder mehr olefinisch ungesättigten photopolymerisierbaren Doppelbindungen allein oder deren Mischungen mit Monomeren mit nur einer olefinisch ungesättigten photopolymerisierbaren Doppelbindung, wobei der Anteil der Monomeren mit nur einer Doppelbindung im allgemeinen nur etwa 5 bis 50 und bevorzugt 5 bis 30 Gewichtsprozent der Gesamtmonomerenmenge beträgt.

Geeignete olefinisch ungesättigte Verbindungen sind Di- und Polyacrylate und -methacrylate, wie sie durch Veresterung von Diolen oder Polyolen mit Acrylsäure oder Methacrylsäure hergestellt werden können, wie die Di- und Tri(meth)acrylate von Äthylenglykol, Diäthylenglykol, Triäthylenglykol, Polyäthylenglykol mit einem Molekulargewicht bis etwa 500, 1,2-Propandiol, 1,3-Propandiol, Neopentylglykol (2,2-Dimethylpropandiol) 1,4-Butandiol, 1,1,1-Trimethylolpropan, Glycerin oder Pentaerithrit; ferner die Monoacrylate und Monomethacrylate solcher Diole und Polyole, wie z.B. Äthylenglykol- oder Di-, Tri- oder Tetraäthylenglykolmonoacrylat, Monomere mit zwei- oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl-(meth)acrylaten hergestellten niedermolekularen Verbindungen. Genannt seien auch Acrylsäure, Methacrylsäure sowie deren Derivate wie (Meth)acrylamid, N-Hydroxymethyl(meth)-acrylamid oder (Meth)acrylate von Monoalkoholen mit 1 bis 6 C-Atomen.

Sehr bewährt haben sich erfindungsgemäße Bindemittel, die polare Monomere und/oder polare polymere Bindemittel enthalten, wie Urethanacrylate oder Epoxidacrylate. Bezüglich geeigneter Bindemittelkomponenten sowie der Anwendung der erfindungsgemäßen Systeme sei auf die DT—OS 1 522 359, 2 200 478, 2 358 948, 2 441 148 verwiesen, wobei die erfindungsgemäß verwendeten Diaminobenzophenon-Verbindungen an die Stelle des dort beschriebenen Michlers Keton treten können.

Geeignete polymere Bindemittelkomponenten sind z.B. Polyamide, Polyurethane, ungesättigte Polyester sowie Polyesterurethane. In bekannter Weise können die erfindungsgemäßen

photopolymerisierbaren Bindemittel mit den üblichen Zusätzen vermischt werden, wie thermischen Polymerisations-inhibitoren, Farbstoffen, Weichmachern usw.

Besondere Bedeutung kommt der größeren Löslichkeit der erfindungsgemäß angewendeten Photosensibilisatoren bei ihrer Verwendung für eine ausreichende Härtung hoch pigmentierter photopolymerisierbarer Systeme zu, insbesondere bei Verwendung hochabsorbierender Pigmente, z.B. in UV-härtenden Druckfarben mit deckendem Schwarz. Gemäß Beispielen 5 und 6 zeigen die hierbei erzielten Drucke eine stark verbesserte Brillanz. Die erfindungsgemäßen Bindemittel eignen sich besonders in Schichtdicken kleiner als 10μm für UV-härtende Druckfarben, aber auch für Offsetdruckplattenbeschichtungen und als Photoresist-Material.

Die in den nachstehenden Beispielen und Vergleichsversuchen genannten Teile und Prozente beziehen sich, soweit nicht anders angegeben, auf das Gewicht.

*Herstellung der substituierten Diaminobenzophenon-Verbindung*

Eine Mischung aus 151 Teilen N-Methyl-N-hydroxyäthylanilin, 16,5 Teilen Paraformaldehyd und 100 Teilen Eisessig wird 1,5 Stunden auf 60 bis 70°C erhitzt. Nach Zugabe von 230 Teilen Methanol, 25 Teilen Chloranil und 2,5 Teilen des Eisenkomplexes des Dihydrodibenzotetraazaannulens zu der Kondensationslösung wird diese bei 50 bis 52°C und 1 bis 3 bar mit Luft behandelt. Die Oxidation wird abgebrochen, wenn fast kein Sauerstoff mehr aufgenommen wird. Aus der auf 10°C abgekühlten Reaktionsmischung kristallisieren farblose Nadeln aus, die abgesaugt und mit 190 Teilen Methanol gewaschen werden. Nach Umkristallisieren aus Methanol werden 885 Teile 4,4'-Bis(N-methyl-N-hydroxyäthylamino)benzophenon erhalten mit einem Schmelzpunkt von 153°C.

Beispiel 1

Durch homogenes Vermischen der Komponenten bei 90 bis 100°C wird ein UV-härtbares Bindemittel hergestellt, bestehend aus 20% eines Urethanacrylats (hergestellt durch Umsetzung eines aliphatischen Biuretisocyanats mit stöchiometrischen Mengen an Hydroxypropylacrylat), 64% eines weiteren Urethanacrylats (hergestellt durch Umsetzung von Hexamethylendiisocyanat mit stöchiometrischen Mengen an Hydroxypropylacrylat), 10% Butandiol-diglycidyläther-diacrylat, 3% Benzophenon und 3% 4,4'-Bis(N-β-hydroxyäthyl-N-methylamino)benzophenon.

Das UV-härtbare Bindemittel ist auch nach 3 monatiger Lagerung bei Raumtemperatur klar.

*Vergleichsversuch A*

Genau wie in Beispiel 1 angegeben wird ein UV-härtbares Bindemittel hergestellt, jedoch anstelle von 3% 4,4'-Bis(N-β-hydroxyäthyl-N-methyl-amino)benzophenon wird 3% 4,4'-Bis(N-dimethylamino)-benzophenon verwendet. Das Bindemittel wird exakt wie jenes von Beispiel 1 etwa 3 Monate lang bei Raumtemperatur gelagert, zeigt dann jedoch eine deutliche Trübung durch feine Kristalle.

Beispiel 2

Ein homogenes Gemisch aus 52% eines Epoxidharz-Acrylats (hergestellt durch Umsetzung eines Bisphenol A-Epichlorhydrin-Harzes mit einem Epoxid-Äquivalentgewicht von 190 mit 97 Mol%, bezogen auf die Epoxidgruppen, reiner Acrylsäure), 40% Pentaerythrittetraacrylat, 4% Benzophenon und 4% 4,4'-Bis(N-β-Hydroxyäthyl-N-methyl-amino)benzophenon wird 3 Monate bei Raumtemperatur gelagert. Die Mischung bleibt klar und ungetrübt.

*Vergleichsversuch B*

Genau wie in Beispiel 2 angegeben wird ein homogenes Gemisch hergestellt, jedoch anstelle von 4% 4,4'-Bis(N-β-hydroxyäthyl-N-methyl-amino)benzophenon werden 4% 4,4'-Bis(N-dimethyl-amino)-benzophenon verwendet. Das Gemisch wird exakt wie jenes von Beispiel 2 3 Monate lang bei Raumtemperatur gelagert. Es zeigt zu diesem Zeitpunkt eine Trübung durch feine Kristalle von 4,4'-Bis(N-dimethyl-amino)benzophenon.

Beispiel 2 und Vergleichsversuch C

Je ein UV-härtendes Bindemittelgemisch aus 30% eines Urethanacrylats (hergestellt durch Umsetzung eines aliphatischen Biuretisocyanats mit stöchiometrischen Mengen an Hydroxypropylacrylat), 54% eines weiteren Urethanacrylats (hergestellt durch Umsetzung von Hexamethylendiisocyanat mit stöchiometrischen Mengen an Hydroxypropylacrylat), 10% N',N'-Divinyl-2-oxo-hexahydropyrimidin, 3% Benzophenon und 3% 4,4'-Bis(N-β-hydroxyäthyl-N-methyl-amino)benzophenon (Beispiel 3) bzw. 3% 4,4'-Bis(N-dimethylamino)benzophenon (Vergleichsversuch C) wird getrennt mittels eines Probedruckgerätes in einer Schichtdicke von etwa 1,3 μm auf Kunstdruckpapier aufgedruckt. Die aus den verschiedenen Bindemittelgemischen hergestellten aufgedruckten Schichten werden auf einer handelsüblichen UV-Härtungsanlage, enthaltend 2 Quecksilbermitteldrucklampen mit je einer Leistung von 80 Watt/cm Bogenlänge bestrahlt, und es wird die maximale Transportbandgeschwindigkeit bestimmt, bei der bei Einschalten nur einer Lampe noch eine sofortige klebfreie und abriebfeste Härtung der aufgedruckten Schicht erzielt werden kann.

Ergebnis
max. Bandgeschwindigkeit: Beispiel 3: 280 m/min
Vergleichsvers. C: 280 m/min

Beispiel 4 und Vergleichsversuch D

In 2 getrennten Ansätzen werden aus
18% eines Blaupigments (C.I. Pigment Blue 15:3)
82% des Bindemittels einschließlich Initiatorsystem von Beispiel 3 (Ansatz=Beispiel 4) sowie aus
18% des vorgenannten Blaupigments und
82% des Bindemittels einschließlich Initiatorsystem von Vergleichsversuch C Ansatz = Vergleichsversuch D)
auf einem Dreiwalzwerk Druckfarben hergestellt. Diese werden getrennt auf Kunstdruckpapiere mittels eines Probedruckgerätes aufgedruckt. Die aufgedruckte Farbmenge wird so eingestellt, daß die Farbdrucke eine optische Dichte von 1,60 bis 1,65 (gemessen mit einem handelsüblichen Auflichtdensitometer) aufweisen. Die Farbdrucke werden wie in Beispiel 3 beschrieben (eine Lampe eingeschaltet) bestrahlt und die maximale Transportbandgeschwindigkeit bestimmt, die beträgt.

| Ansatz | max. Bandgeschwindigkeit |
|---|---|
| Beispiel 4 | |
| a) frische Druckfarbe | 160 m/min |
| b) Druckfarbe 2 Wochen gelagert | 160 m/min |
| Vergleichsversuch D | |
| a) frische Druckfarbe | 150 m/min |
| b) Druckfarbe 2 Wochen gelagert | 130 m/min |

Die Druckfarbe des Vergleichsversuches D weist nach 2-wöchiger Lagerung eine mattere, körnige Oberfläche auf. Unter dem Mikroskop sind feine Kristalle von 4,4'-Bis(N-dimethylamino)benzophenon) erkennbar.

Beispiel 5 und Vergleichsversuch E

in 2 getrennten Ansätzen werden aus
18% Ruß und
82% des Bindemittels einschließlich Initiatorsystem von Beispiel 3 (Ansatz=Beispiel 5) sowie aus
18% Ruß und
82% des Bindemittels einschließlich Initiatorsystem von Vergleichsversuch C (Ansatz=Vergleichsversuch E)
UV-härtende Druckfarben und mit ihnen Farbdrucke auf Kunstdruckpapier mit einer optischen Dichte von 2,0 bis 2,1 hergestellt. Die Farbdrucke werden wie in Beispiel 3 beschrieben (jedoch sind beide Lampen eingeschaltet) bestrahlt und die maximale Transportbandgeschwindigkeit bestimmt, die beträgt.

| Ansatz | max. Bandgeschwindigkeit |
|---|---|
| Beispiel 5 | |
| a) frische Druckfarbe | 125 m/min |
| b) Druckfarbe 2 Wochen gelagert | 125 m/min |
| Vergleichsversuch E | |
| a) frische Druckfarbe | 80 m/min |
| b) Druckfarbe 2 Wochen gelagert | 70 m/min |

Auch hier zeigte die Probe des Vergleichsversuchs E nach 2-wöchiger Lagerung infolge einer Kristallisation von 4,4'-Bis(N-dimethylamino)benzophenon eine mattere Oberfläche.

**Patentansprüche**

1. Photopolymerisierbare Bindemittel für Druckfarben, Überzüge und Druckplatten, im wesentlichen bestehend aus mindestens einer photopolymerisierbaren olefinisch ungesättigten Verbindung sowie gegebenenfalls einer polymeren Bindemittelkomponente, die eine N,N'-substituierte Diaminobenzophenon-Verbindung als Photosensibilisator enthalten, dadurch gekennzeichnet, daß sie eine Diaminobenzophenon-Verbindung der Formel I

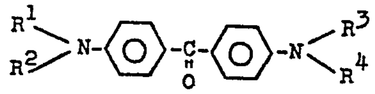 (I)

enthalten, worin $R^1$ und $R^3$ $H(OR^5)_x$-Reste mit $R^5$=Alkylen mit 2 bis 3 C-Atomen und x=1, 2 oder 3, $R^2$ und $R^4$ Alkylreste mit 1 bis 4 C-Atomen oder Reste der für $R^1$ und $R^3$ genannten Art darstellen.

2. Photopolymerisierbare Bindemittel gemäß Anspruch 1, dadurch gekennzeichnet, daß sie neben einer Diaminobenzophenon-Verbindung der Formel (I) Benzophenon oder ein im Bereich von 300 bis 380 nm niedrig absorbierendes Benzophenonderivat enthalten.

3. Photopolymerisierbare Bindemittel gemäß Anspruch 1, dadurch gekennzeichnet, daß sie als Diaminobenzophenon-Verbindung der Formel (I) 4,4'-Bis(N-hydroxyäthyl-N-$C_1$—$C_4$-alkyl-amino)-benzophenon enthalten.

**Claims**

1. A photopolymerizable binder for printing inks, coatings and printing plates, which consists essentially of at least one photopolymerizable olefinically unsaturated compound, with or without a polymeric binder component, and contains an N,N'-substituted diaminobenzophenone compound as photosensitizer, characterised in that it contains a diaminobenzophenone compound of the formula (I)

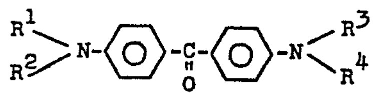 (I)

where $R^1$ and $R^3$ are $H(OR^5)_x$ radicals, $R^5$ being alkylene of 2 to 3 carbon atoms and x being 1, 2 or 3, and $R^2$ and $R^4$ are each alkyl of 1 to 4 carbon atoms or are radicals of the type of $R^1$ and $R^3$.

2. A photopolymerizable binder as claimed in claim 1, characterized in that it contains, in addition to a diaminobenzophenone compound of the formula (I), benzophenone or a benzophenone derivative which has a low absorption in the range from 300 to 380 nm.

3. A photopolymerizable binder as claimed in claim 1, characterized in that it contains 4,4'-bis-(N-hydroxyethyl-N-alkylamino)-benzophenone, where alkyl is of 1 to 4 carbon atoms, as the diaminobenzophenone compound of the formula (I).

**Revendications**

1. Liants photopolymérisables pour encres d'impression, enduits et clichés, constitués essentiellement d'au moins un composé photopolymérisable, à insaturation oléfinique ainsi qu'éventuellement d'un composant de liant polymère, qui contiennent, comme photosensibilisateur, un dérivé de diaminobenzophénone substituée en N,N', caractérisés par le fait qu'ils contiennent un dérivé de diaminobenzophénone de formule I

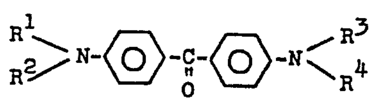 (I)

où $R^1$ et $R^3$ représentent des restes $H(OR^5)_x$ avec $R^5$=alkylène à 2 ou 3 atomes C et x=1, 2 ou 3, $R^2$ et $R^4$ représentent des restes alkyle à 1 à 4 atomes C ou des restes de la nature indiquée pour $R^1$ et $R^3$.

2. Liants photopolymérisables selon la revendication 1, caractérisés par le fait qu'ils contiennent, outre un dérivé de diaminobenzophénone de formule I, de la benzophénone ou un dérivé de benzophénone peu absorbant dans le domaine de 300 à 380 nm.

3. Liants photopolymérisables selon la revendication 1, caractérisés par le fait qu'ils contiennent comme dérivé de diaminobenzophénone de formule I, de la 4,4'-bis(N-hydroxyéthyl-N-$C_1$—$C_4$-alkylamino)benzophénone.